(19) **Europäisches Patentamt**
**European Patent Office**
**Office européen des brevets**

(11) **EP 4 492 528 A2**

(12) **EUROPEAN PATENT APPLICATION**

(43) Date of publication:
**15.01.2025  Bulletin 2025/03**

(21) Application number: **24184025.5**

(22) Date of filing: **24.06.2024**

(51) International Patent Classification (IPC):
**H01M 10/42** (2006.01)    **G01R 31/367** (2019.01)
**G01R 31/3828** (2019.01)    **G01R 31/3842** (2019.01)
**H01M 10/48** (2006.01)    **H01M 10/44** (2006.01)

(52) Cooperative Patent Classification (CPC):
**H01M 10/48; G01R 31/367; G01R 31/3828;**
**G01R 31/3842; H01M 10/425; H01M 10/44;**
**H01M 2010/4271**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **14.07.2023  JP 2023115766**

(71) Applicant: **TOYOTA JIDOSHA KABUSHIKI**
**KAISHA**
**Aichi-ken, 471-8571 (JP)**

(72) Inventors:
• **FUJIWARA, Mai**
 **Toyota-shi, 471-8571 (JP)**
• **NISHI, Yuji**
 **Toyota-shi, 471-8571 (JP)**
• **KAWAHARA, Shingo**
 **Toyota-shi, 471-8571 (JP)**
• **KONDO, Hiroki**
 **Toyota-shi, 471-8571 (JP)**
• **SASAKI, Tsuyoshi**
 **Toyota-shi, 471-8571 (JP)**

(74) Representative: **D Young & Co LLP**
**3 Noble Street**
**London EC2V 7BQ (GB)**

(54) **METHOD OF MANAGING STORAGE BATTERY AND BATTERY MANAGEMENT SYSTEM**

(57)    A positive electrode active material (121) includes: a rich phase in which charge carriers are high in content; a poor phase in which the charge carriers are low in content; and a two-phase coexistence phase in which the rich phase and the poor phase coexist. A method of managing a battery (10) includes, in a many particle model in which the positive electrode active material (121) is represented by a plurality of particles each distinguished by a particle number indicating a reaction sequence of the positive electrode active material (121), assuming that the charge carriers are equal in content among one or more particles belonging to each of the rich phase, the poor phase, and the two-phase coexistence phase: calculating an overvoltage of each of the particles for each of the phases; calculating a reaction current density based on the overvoltage for each of the phases; and estimating an SOC of the storage battery (10) based on the reaction current density in each of the phases.

FIG.16

EP 4 492 528 A2

**Description**

CROSS REFERENCE TO RELATED APPLICATIONS

This nonprovisional application is based on Japanese Patent Application No. 2023-115766 filed on July 14, 2023 with the Japan Patent Office, the entire contents of which are hereby incorporated by reference.

BACKGROUND

Field

The present disclosure relates to a method of managing a storage battery and a battery management system.

Description of the Background Art

A technique for improving the accuracy of estimating the state of charge (SOC) of a storage battery has been proposed. NPL 1 (Hiroki Kondo, Tsuyoshi Sasaki, Pallab Barai, and Venkat Srinivasan; Comprehensive Study of the Polarization Behavior of LiFePO4 Electrodes Based on a Many-Particle Model (Journal of The Electrochemical Society, Volume 165, Number 10, published on 6 July 2018)), and NPL 2 (Tsuyoshi Sasaki, Yoshio Ukyo, and Petra Novak; Memory effect in a lithium-ion battery (Nature materials, Volume 12, June 2013)) disclose a technique for estimating the SOC of a storage battery having a positive electrode containing lithium iron phosphate by applying a many particle model (MPM). The many particle model is a model for formulating an electrochemical phenomenon related to SOC estimation by representing an active material (a positive electrode active material in NPLs 1 and 2) contained in an electrode by a large number of particles.

SUMMARY

By employing the many particle model, the accuracy of estimating the SOC can be improved as compared with a one-particle model. On the other hand, the computation load on a processor may be increased. More specifically, in the many particle model, a variable is used for each particle, and thus, a memory capacity of (the number of particles) × (memory usage per particle) needs to be ensured. Therefore, for example, if thousands of particles are used, the memory usage may excessively increase, with the result that the computation load on the processor may become excessively large. This problem becomes particularly noticeable when a computation processing unit (a vehicle-mounted electronic control unit (ECU), a mobile terminal, and the like) with limited computing resources is used.

The present disclosure has been made in order to solve the above-described problems, and an object of the present disclosure is to reduce a computation load on a processor while estimating an SOC of a storage battery with high accuracy.

A method of managing a storage battery according to an aspect of the present disclosure is to manage, by a processor, a storage battery having a positive electrode containing a positive electrode active material. The positive electrode active material has a plurality of phases that are different from each other in content of charge carriers in the positive electrode active material. The plurality of phases include: a rich phase in which the charge carriers are high in content; a poor phase in which the charge carriers are low in content; and a two-phase coexistence phase in which the rich phase and the poor phase coexist. The method includes first to third steps performed in a many particle model in which the positive electrode active material is represented by a plurality of particles each distinguished by a particle number indicating a reaction sequence of the positive electrode active material, assuming that the charge carriers are equal in content among one or more particles belonging to each of the rich phase, the poor phase, and the two-phase coexistence phase. The first step is a step of, for each of the plurality of phases, calculating an overvoltage of a particle belonging to a corresponding one of the plurality of phases by the processor based on a measured voltage of the storage battery, a measured current of the storage battery, and an open-circuit potential of the particle belonging to the corresponding one of the plurality of phases. The second step is a step of, for each of the plurality of phases, calculating a reaction current density by the processor based on the overvoltage. The third step is a step of estimating an SOC of the storage battery by the processor based on the reaction current density in each of the plurality of phases.

In the above-descried method, the SOC of the storage battery can be estimated with high accuracy by using the many particle model. Further, by assuming that the charge carriers are equal in content among the particles belonging to each of the rich phase, the poor phase, and the two-phase coexistence phase, the overvoltages (and the reaction current densities based on the overvoltages) of all the particles belonging to each phase are collectively calculated. Thereby, the computation load on the processor can be reduced as compared with the case where the overvoltage (and the reaction current density) is calculated separately for each particle. Therefore, according to the above-described method, the computation load on the processor can be reduced while estimating the SOC of the storage battery with high accuracy.

The foregoing and other objects, features, aspects, and advantages of the present disclosure will become apparent from the following detailed description of the present disclosure when taken in conjunction with the accompanying drawings.

BRIEF DESCRIPTION OF THE DRAWINGS

Fig. 1 is a diagram schematically showing an overall configuration of a vehicle equipped with a battery management system according to an embodiment of the present disclosure.

Fig. 2 is a perspective view schematically showing an example of a configuration of a cell.

Fig. 3 is a diagram showing an example of a configuration of an electrode assembly.

Fig. 4 is a diagram showing a relation between a lithium composition and an open-circuit potential of a positive electrode active material assuming that the positive electrode active material is a single particle in an iron phosphate lithium ion battery.

Fig. 5 is a conceptual diagram for illustrating a many particle model.

Fig. 6 is a flowchart illustrating a processing procedure of an SOC estimation process using a comparative model.

Fig. 7 is a conceptual diagram for illustrating a reaction sequence in the comparative model.

Fig. 8 is a conceptual diagram for illustrating how each particle undergoes phase transition in the comparative model.

Fig. 9 is a conceptual diagram for illustrating a current flowing through each particle in the comparative model.

Fig. 10 is a first conceptual diagram for illustrating a difference between the comparative model and a simplified model.

Fig. 11 is a second conceptual diagram for illustrating the difference between the comparative model and the simplified model.

Fig. 12 is a third conceptual diagram for illustrating the difference between the comparative model and the simplified model.

Fig. 13 is a diagram for comparing the concept of phase transition of many particles between the comparative model and the simplified model.

Fig. 14 is a diagram for illustrating phase transition of many particles resulting from discharging of a battery.

Fig. 15 is a diagram for illustrating phase transition of many particles resulting from charging of the battery.

Fig. 16 is a flowchart illustrating a first example of a processing procedure of an SOC estimation process using the simplified model in the present embodiment.

Fig. 17 is a flowchart illustrating a second example of the processing procedure of the SOC estimation process using the simplified model in the present embodiment.

Fig. 18 is a conceptual diagram for illustrating bar-coding of a variable.

Fig. 19 is a diagram for illustrating a first additional rule.

Fig. 20 is a diagram for illustrating second and third additional rules.

DESCRIPTION OF THE PREFERRED EMBODIMENTS

The following describes embodiments of the present disclosure in detail with reference to the accompanying drawings, in which the same or corresponding portions are denoted by the same reference characters, and the description thereof will not be repeated.

The following describes an example of a configuration in which a battery management system (BMS) according to the present disclosure is mounted in a hybrid electric vehicle (HEV), more specifically, a plug-in hybrid electric vehicle (PHEV). However, the battery management system according to the present embodiment is applicable to all types of vehicles on which a storage battery for traveling is mounted. In other words, the battery management system according to the present embodiment may be mounted also in a battery electric vehicle (BEV), a fuel cell electric vehicle (FCEV), and the like. Further, the battery management system according to the present disclosure is not necessarily applied only for a vehicle but may be applied also for stationary use.

[Embodiments]

<Overall Configuration>

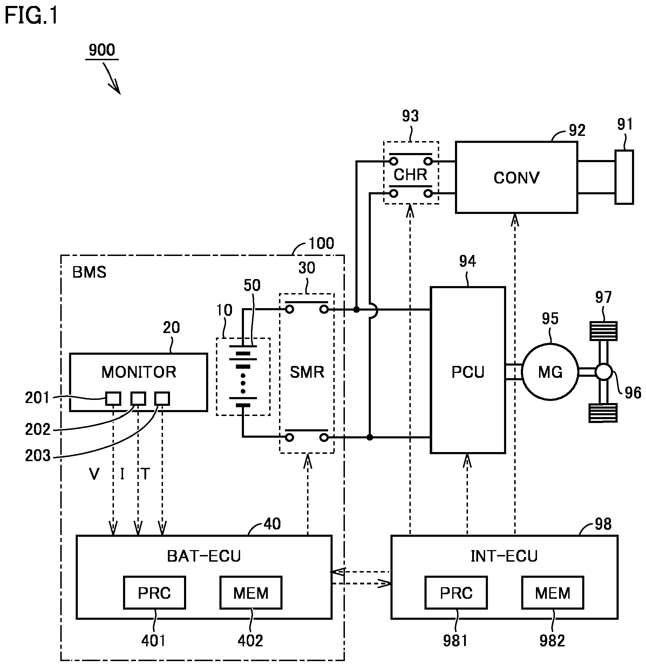

Fig. 1 is a diagram schematically showing an overall configuration of a vehicle equipped with a battery management system according to an embodiment of the present disclosure. A vehicle 900 includes a battery management system 100. Battery management system 100 is a battery pack and includes a battery 10, a monitoring unit 20, a system main relay (SMR) 30, and a battery electronic control unit (ECU) 40. Vehicle 900 further includes an inlet 91, a power conversion device 92, a charging relay 93, a power control unit (PCU) 94, a motor generator 95, a power transmission gear 96, a driving wheel 97, and an integrated ECU 98.

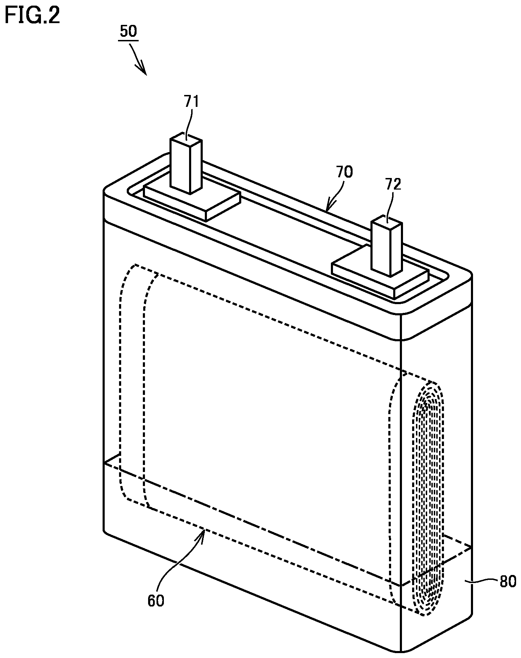

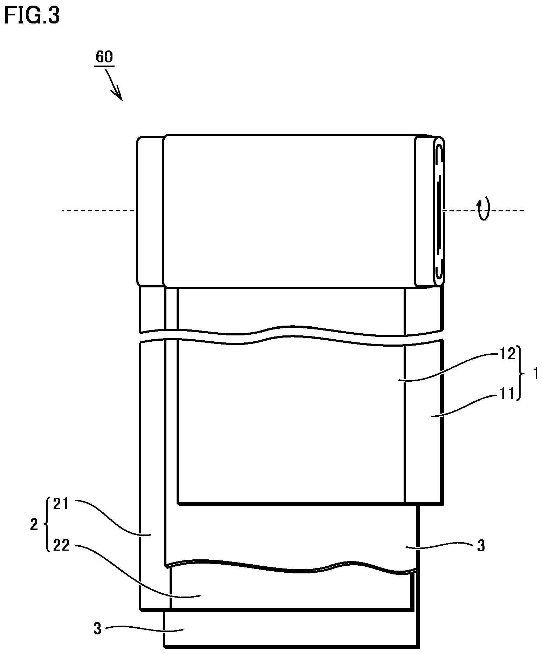

Battery 10 stores electric power for driving motor generator 95 and supplies the stored electric power to motor generator 95 through PCU 94. When motor generator 95 generates electric power, battery 10 is charged with the generated electric power received through PCU 94. Battery 10 is a battery assembly including one or more battery modules. Each of the one or more battery modules includes a plurality of cells 50. Each cell 50 is a lithium ion secondary battery. The configuration of cell 50 will be described with reference to Figs. 2 and 3.

Monitoring unit 20 includes various sensors for monitoring the state of battery 10. Specifically, monitoring unit 20 includes a voltage sensor 201, a current sensor 202, and a temperature sensor 203. Voltage sensor 201 detects a voltage V of battery 10 (each cell). Current sensor 202 detects a current I supplied to and discharged from battery 10. Temperature sensor 203 detects a temperature T of battery 10. Each sensor outputs a signal indicating the detection result to battery ECU 40.

SMR 30 is provided on a power line that connects battery 10 and PCU 94. When SMR 30 is closed, battery 10 can be charged and discharged.

Battery ECU 40 includes a processor 401 and a memory 402. Processor 401 is an arithmetic processing unit such as a central processing unit (CPU) or a micro processing unit (MPU). Memory 402 is a storage device including a read only memory (ROM) and a random access memory (RAM). Memory 402 stores a system program including an operating system (OS), a control program including a computer-readable code necessary for control computation, and various parameters for managing battery 10. Processor 401 reads the system program, the control program, and the parameters, deploys them in memory 402 for execution, and thereby implement various processes. In the present embodiment, the main process executed by processor 401 includes a process of estimating the state of charge (SOC) of battery 10 (each cell in the battery assembly). This process will be described later in detail.

Inlet 91 is configured to be capable of connecting a charging connector (not shown) provided at the tip end of a charging cable through mechanical coupling. Connection between inlet 91 and the charging connector ensures an electrical connection between a charging facility (not shown) and vehicle 900. Further, integrated ECU 98 of vehicle 900 and a controller (not shown) in the charging facility can exchange various signals.

Power conversion device 92 is, for example, an alternating-current (AC)/direct-current (DC) converter. Power conversion device 92 converts AC power supplied from the charging facility through the charging cable into DC power with which battery 10 is charged.

Charging relay 93 is electrically connected to a power line that connects SMR 30 and PCU 94. When charging relay 93 is closed and SMR 30 is closed, power transmission between inlet 91 and battery 10 is enabled.

PCU 94 is electrically connected between SMR 30 and motor generator 95. PCU 94 includes a converter and an inverter (each of which is not shown), and drives motor generator 95 in response to a command from integrated ECU 98.

Motor generator 95 is an AC rotating electric machine and is, for example, a permanent magnet-type synchronous motor including a rotor having a permanent magnet embedded therein. The output torque of motor generator 95 is transmitted to driving wheel 97 through power transmission gear 96 to cause vehicle 900 to travel. Further, during a braking operation of vehicle 900, motor generator 95 generates electric power with rotational force of driving wheel 97. The electric power generated by motor generator 95 is converted by PCU 94 into charging power for battery 10.

Integrated ECU 98 includes a processor 981 and a memory 982. Processor 981 executes various control operations for controlling vehicle 900 to be brought into a desired state based on signals received from various sensors and also on programs and maps stored in memory 982. For example, integrated ECU 98 controls PCU 94 in cooperation with battery ECU 40 to thereby control charging and discharging of battery 10.

<Cell Configuration>

Fig. 2 is a perspective view schematically showing an example of the configuration of cell 50. Fig. 2 is a perspective view showing the inside of cell 50. Cell 50 is a sealed rectangular battery in the present example. Cell 50 may have a cylindrical shape, for example. Alternatively, cell 50 may constitute a bipolar-type stacked battery assembly. Cell 50 includes an electrode assembly 60, a battery case 70, and an electrolyte solution 80. Battery case 70 includes a positive electrode terminal 71 and a negative electrode terminal 72.

Electrode assembly 60 has, for example, a flat rectangular parallelepiped outer shape. Electrode assembly 60 is accommodated in battery case 70 such that the long side of the flat rectangular parallelepiped extends in a long-side direction of battery case 70. Battery case 70 may be made of metal such as an aluminum (Al) alloy, for example. Battery case 70 may be, for example, a pouch formed of an Al laminate film or the like. Electrolyte solution 80 is introduced into battery case 70 in which electrode assembly 60 is impregnated with electrolyte solution 80. The liquid level of electrolyte solution 80 is indicated by a dash-dotted line.

Fig. 3 is a diagram showing an example of the configuration of electrode assembly 60. Referring to Figs. 2 and 3, electrode assembly 60 is formed by winding a stack consisting of a positive electrode 1 and a negative electrode 2 alternately stacked with a separator 3 interposed therebetween. Fig. 3 shows an exploded view of the stack while being wound.

Positive electrode 1 has a sheet shape and includes a positive electrode current collector 11 and a positive electrode composite material layer 12. Positive electrode current collector 11 is electrically connected to positive electrode terminal 71. Positive electrode current collector 11 may be, for example, an aluminum (Al) foil, an Al alloy foil, or the like.

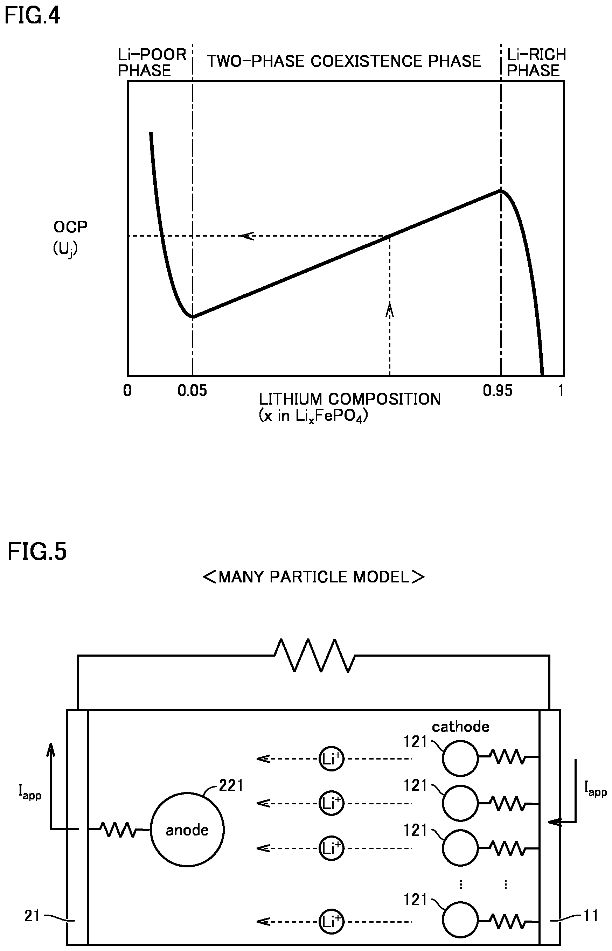

In the present example, positive electrode composite material layer 12 is formed on both the front surface and the back surface of positive electrode current collector 11. However, positive electrode composite material layer 12 may be formed only on the front surface (one of the surfaces) of positive electrode current collector 11. Positive electrode composite material layer 12 contains a positive electrode active material 121 (see Fig. 5), a conductive material (not shown), and a binder (not shown). Positive electrode active material 121 is a two-phase coexistence material (described later), which is, for example, iron phosphate ($LiFePO_4$). Two or more types of positive electrode active materials may be used in combination. The conductive material may contain, for example, at least one selected from the group consisting of carbon black (acetylene black and the like), vapor grown carbon fibers (VGCF), carbon nanotubes (CNT), and graphene flakes. The binder may contain, for example, at least one selected from the group consisting of carboxymethyl cellulose (CMC), styrenebutadiene rubber (SBR), polyvinylidene difluoride (PVdF), and polytetrafluoroethylene (PTFE).

Negative electrode 2 has a sheet shape and includes a negative electrode current collector 21 and a negative electrode composite material layer 22. Negative electrode current collector 21 is electrically connected to negative electrode terminal 72. Negative electrode current collector 21 may be, for example, a copper (Cu) foil.

In the present example, negative electrode composite material layer 22 is formed on both the front surface and the back surface of negative electrode current collector 21. However, negative electrode composite material layer 22 may be formed only on the front surface (one of the surfaces) of negative electrode current collector 21. Negative electrode composite material layer 22 contains a negative electrode active material 221 and a binder (not shown). Negative electrode active material 221 may be, for example, a carbon-based negative electrode active material such as natural graphite, soft carbon, or hard carbon, or may be an alloy-based negative electrode active material containing silicon (Si), tin (Sn), or the like. For a binder, a material applicable as a binder contained in the positive electrode active material layer is used.

Separator 3 is a strip-shaped film. Separator 3 is disposed between positive electrode 1 and negative electrode 2 to provide electrical insulation between positive electrode 1 and negative electrode 2. The material of separator 3 may be, for example, a porous film made of a polyolefin-based resin such as polyethylene (PE) or polypropylene (PP), may be a polyamide-based resin such as nylon and aromatic polyamide (aramid), or may be a woven fabric or a nonwoven fabric made of polypropylene, polyethylene terephthalate (PET), methyl cellulose, or the like.

Electrolyte solution 80 contains at least a lithium (Li) salt and a solvent. The Li salt is a supporting electrolyte dissolved in the solvent. The Li salt may be, for example, $LiPF_6$. The solvent is aprotic. The solvent may be, for example, a mixture of cyclic carbonate and chain carbonate. Electrolyte solution 80 may further contain a known functional additive in addition to the Li salt and the solvent.

<Lithium Composition Versus OCP>

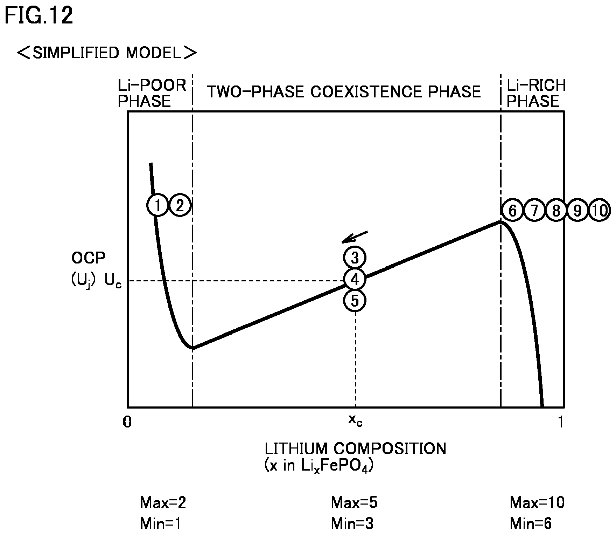

Fig. 4 is a diagram showing the relation between a lithium composition and an open-circuit potential (OCP) of the positive electrode active material assuming that the positive electrode active material is a single particle in an iron phosphate lithium ion battery. The horizontal axis represents the lithium composition in the positive electrode active material. The lithium composition is x ($0 \leq x \leq 1$) indicating the lithium content in $Li_xFePO_4$. The lithium composition corresponds to the "content of charge carriers" according to the present disclosure. The vertical axis represents the OCP of the positive electrode active material. The same also applies to Fig. 12, which will be described later.

The lithium composition-OCP curve shown in Fig. 4 has a maximum point and a minimum point, each of which is a spinodal point. In general, during charging or discharging of an iron phosphate lithium ion battery, the positive electrode active material has a Li-rich phase, a Li-poor phase, and a two-phase coexistence phase. The Li-rich phase is a region having a lithium composition higher than the local maximum point (x = 0.95 in the present example) of the lithium composition-OCP curve. The Li-poor phase is a region having a lithium composition lower than the local minimum point (x = 0.05 in the present example) of the lithium composition-OCP curve. The Li-rich phase and the Li-poor phase each are a solid solution phase. The two-phase coexistence phase is a region that is located between the Li-rich phase and the Li-poor phase, and in which the Li-rich phase and the Li-poor phase coexist.

Between two spinodal points (the local maximum point and the local minimum point), the OCP of the positive electrode active material decreases substantially in proportion to the decrease of a lithium composition x. In the present example, the voltage difference between the two spinodal points is about 20 mV. An average voltage $V_{ave}$ at the two spinodal points (the balanced voltage in the two-phase coexistence phase) is about 3.43 V. In the actual iron phosphate lithium ion battery, the positive electrode active material contains many particles, so that the lithium composition-OCP curve that is flat between x = 0.05 and x = 0.95 is observed.

<Many Particle Model>

In the present embodiment, a many particle model (MPM) is adopted to estimate the SOC of battery 10.

Fig. 5 is a conceptual diagram for illustrating a many particle model. In a one-particle model, the positive electrode active material is schematically represented as one particle, and the negative electrode active material is schematically represented as one particle.

On the other hand, in the many particle model, in consideration of the polarization behavior of the lithium iron phosphate positive electrode, it is assumed that this positive electrode is composed of a plurality of (N) spherical particles electronically and ionically connected to each other. In the many particle model, positive electrode active material 121 is schematically represented as many particles. Negative electrode active material 221 is schematically represented as one particle in the present example, but may also be represented as many particles.

Fig. 5 shows the state in which battery 10 is charged. When battery 10 is charged, lithium ions (denoted as Li⁺) are desorbed from positive electrode active material 121 while lithium ions are inserted into respective negative electrode active materials 221. At this time, a current (an applied current $I_{app}$ described later) flows through battery 10. Although not shown, when battery 10 is discharged, the current flows in the direction opposite to the direction shown in Fig. 5.

By using the many particle model, the accuracy of estimating the SOC can be improved as compared with the case where the one-particle model is used. On the other hand, the computation load on processor 401 may be increased. More specifically, in the many particle model, one or more variables are used for each particle. Also, several thousands of particles are required to maintain the smoothness of the computation results among the particles in the many particle model. Further, since the SOC may vary among the cells, it is desirable to estimate the SOC for each cell 50. In this case, in order to obtain smooth computation results for all the cells, the memory capacity corresponding to (memory usage per particle) × (several thousands of particles) × (several tens of cells) needs to be ensured. Thus, the usage of memory 402 becomes excessively large, which may result in an excessively high computation load on processor 401. This problem becomes particularly noticeable in the case where the computation resources are limited as in on-vehicle battery ECU 40.

Thus, in the present embodiment, a simplified many particle model is adopted in order to reduce the computation load on processor 401. This model is simply referred to as a "simplified model". In contrast, the many particle model that is not simplified is referred to as a "comparative model". In order to facilitate understanding of the simplified model, the following first describes the SOC estimation process using the comparative model. The details of the comparative model may be obtained with reference to Japanese Patent Laying-Open No. 2018-169398.

<Comparative Model>

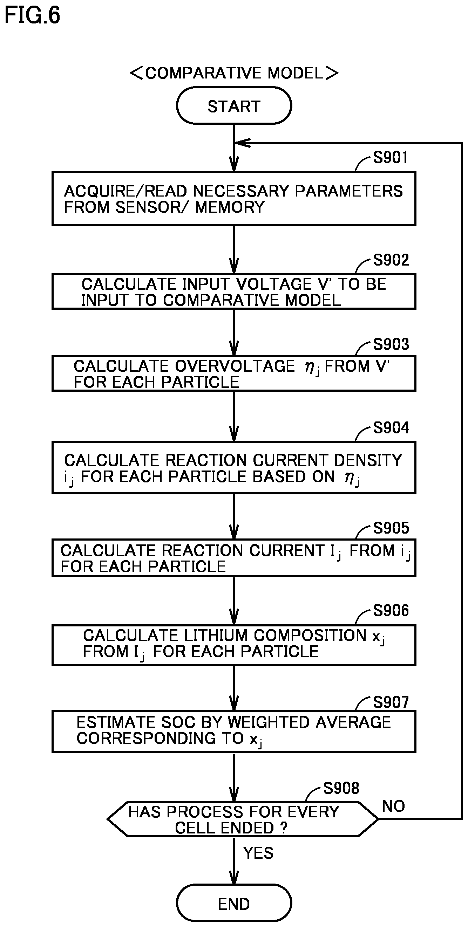

Fig. 6 is a flowchart illustrating a processing procedure of the SOC estimation process using the comparative model. In the present example, the SOC estimation process is executed for each cell. A cell to be subjected to the SOC estimation process is referred to as a "target cell". The SOC estimation process is repeatedly executed. The value (a present value) in the present SOC estimation process is denoted as (t), and the value (a previous value) in the previous SOC estimation process is denoted as (t-1).

In step S901, the processor acquires various variables (parameters) used in the present SOC estimation process from the sensor or reads these various variables from memory 402.

In step S902, according to the equation (1), the processor calculates a voltage V'(t) that is to be input to the comparative model.

$$V'(t) = V(t) - I(t) \cdot R_d - dV_c(t) \qquad \cdots (1)$$

In the equation (1), V(t) denotes a present value of a closed circuit voltage (CCV) in the target cell that is measured by the voltage sensor. I(t) denotes a present value of the current measured by the current sensor. Rd denotes a DC resistance of the target cell (an impedance component related to movement of lithium ions and electrons between the positive electrode and the negative electrode). Further, dVc(t) denotes a present value of the salt concentration overvoltage resulting from the concentration gradient of lithium ions between the positive electrode active material and the negative electrode active material, and is calculated according to the equation (2). Further, $\alpha$ and $\beta$ each denote a coefficient adaptively determined by experiments or simulations conducted in advance.

$$dV_c(t) = (1 - \alpha) \cdot dV_c(t - 1) + \beta \cdot I(t) \qquad \cdots (2)$$

In the many particle model, it is required to set a reaction sequence, i.e., the order of particles involved in the reaction (insertion/desorption of lithium ions) in the many particles. In actual storage batteries, various factors may be related to the reaction sequence. Specific examples of the factors include the distance from the current collector foil to the positive electrode active material, the distance from the current collector terminal to the positive electrode active material, the particle diameter of the positive electrode active material, and the like. In the comparative model disclosed in PTL 1, the reaction sequence is determined by the particle diameter according to the logarithmic normal distribution (see Fig. 1(c) in PTL 1).

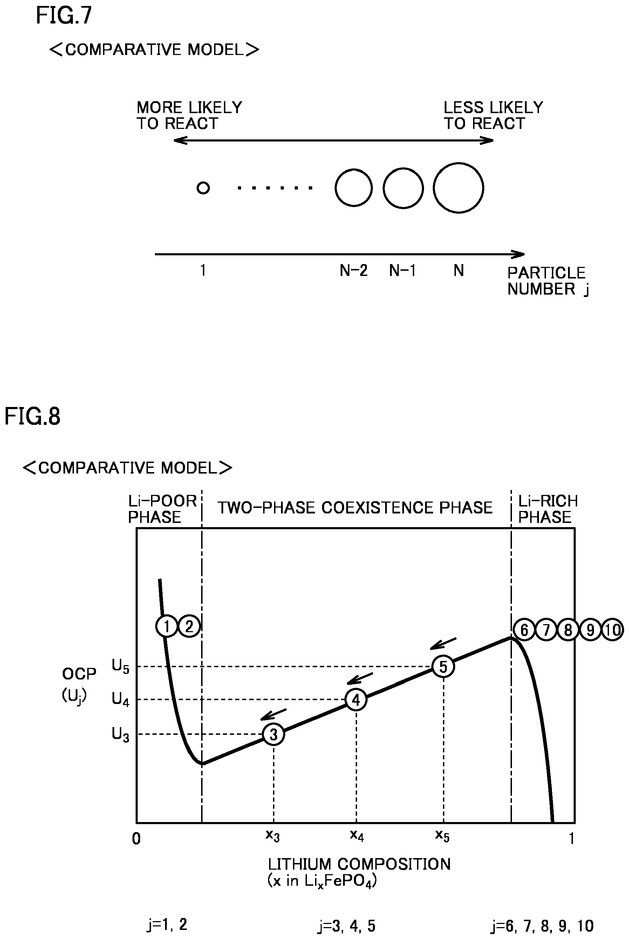

Fig. 7 is a conceptual diagram for illustrating the reaction sequence in the comparative model. In the many particle model in which the reaction sequence is determined by each particle diameter, all particles are assumed to be spherical. Thus, when the radius of the j-th particle (j is a natural number for distinguishing the particles from each other) is defined as $r_j$, a surface area $S_j$ of the j-th particle is $4\pi r_j$ ($S_j = 4\pi r_j$), and a volume $V_j$ of the j-th particle is $4\pi r_j^3/3$ ($V_j = 4\pi r_j^3/3$). In this case, j = 1 to N.

Surface area $S_j$ of a particle is a parameter for representing the reaction area of the positive electrode active material. Volume $V_j$ of a particle is a parameter for representing the capacity of the positive electrode active material. The surface area/volume ($S_j/V_j$) of a particle corresponds to the reaction area/volume of the positive electrode active material. A particle whose particle diameter is smaller is larger in surface area/volume of the particle, and thus, the lithium composition is more likely to change. A particle whose lithium composition is more likely to change is higher in reaction sequence and is assigned with a smaller particle number. Therefore, the particle having particle number 1 is the highest in the reaction sequence, and the particle having particle number N is the lowest in the reaction sequence.

As the target cell is charged or discharged, the plurality of particles undergo phase transition sequentially in order from the particle higher in reaction sequence (from the particle smaller in particle number).

Fig. 8 is a conceptual diagram for illustrating how each particle undergoes phase transition in the comparative model. For simplicity, the following shows an example in which the total number N of particles is 10 (N = 10). In this case, all the particles originally belong to the Li-rich phase. As the target cell is charged, the particles having particle numbers j of 1 and 2 (j = 1, 2) undergo phase transition to the Li-poor phase through the two-phase coexistence phase, and the particles having particle numbers j of 3 to 5 (j = 3 to 5) undergo phase transition to the two-phase coexistence phase. In this way, in the comparative model, all the particles are separately treated.

The phase to which each of ten particles belongs is represented by a lithium composition $x_j$ of the corresponding particle. When lithium composition $x_j$ of the corresponding particle is determined, an open-circuit potential $U_j$ of the corresponding particle is determined according to the lithium composition-OCP curve.

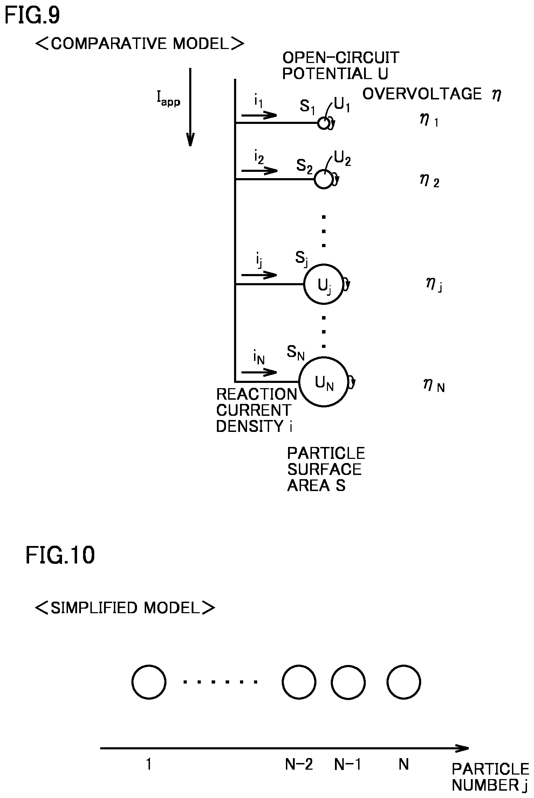

Fig. 9 is a conceptual diagram for illustrating the current flowing through each particle in the comparative model. In the comparative model, it is assumed that applied current $I_{app}$ flowing through the target cell is distributed to a plurality of particles according to an overvoltage $\eta_j$ corresponding to lithium composition $x_j$ of each particle. The current distributed to the j-th particle is described using reaction current density $i_j$.

Referring back to Fig. 6, in step S903, the processor calculates overvoltage $\eta_j$ of each of the plurality of particles. Specifically, for each particle, the processor subtracts open-circuit potential $U_j$ of the j-th particle from a voltage V' calculated according to the above-mentioned equations (1) and (2) to thereby calculate overvoltage $\eta_j$ of the corresponding particle (see the equation (3)). Overvoltage $\eta_j$ is a difference between the CCV of the target cell and an open circuit voltage (OCV) of the corresponding particle.

$$\eta_j(t) = V'(t) - U_j(x_j(t-1)) \qquad \cdots (3)$$

In the equation (3), open-circuit potential $U_j$ is a function of lithium composition $x_j$ and is calculated based on the lithium composition-OCP curve shown in Fig. 8. More specifically, the processor calculates the open-circuit potential corresponding to a previous value $x_j(t-1)$ of the lithium composition as $U_j$ in the lithium composition-OCP curve.

In step S904, the processor calculates a reaction current density $i_j$ for each particle based on overvoltage $\eta_j$ calculated in step S903. More specifically, reaction current density $i_j$ is calculated according to the following equation (4) as the Butler-Volmer equation. In this case, $i_{Oj}$ denotes an exchange current density and shows a value determined in advance according to the particle number. F denotes a Faraday constant. R denotes a gas constant. T denotes a temperature measured by a temperature sensor.

$$i_j = i_{Oj}\left[\exp\left(\frac{0.5F}{RT}\eta_j\right) - \exp\left(\frac{-0.5F}{RT}\eta_j\right)\right] \qquad \cdots (4)$$

In step S905, the processor calculates a reaction current $I_j$ flowing through the j-th particle by the product of reaction current density $i_j$ of each of the plurality of particles calculated in step S903; and surface area $S_j$ of the corresponding particle (see the equation (5)).

$$I_j(t) = S_j \cdot i_j(t) \qquad \cdots (5)$$

In step S906, the processor divides, by a capacity $Q_j$ of the j-th particle, the product of reaction current $I_j$ calculated in step S905 and a period $\Delta t$ of the SOC estimation process (the time period between the present SOC estimation process and the previous SOC estimation process). The processor calculates the value obtained by adding the divided value to the previous value ($x_j$(t-1)) of the lithium composition of the corresponding particle as a present value $x_j$(t) of the lithium composition of the corresponding particle (see the equation (6)). The equation (6) shows that lithium composition $x_j$ changes by an amount (an amount of charge) proportional to reaction current $I_j$.

$$x_j(t) = x_j(t-1) + \frac{I_j(t) \cdot \Delta t}{Q_j} \qquad \cdots (6)$$

In step S907, the processor estimates the SOC of the target cell by calculating a weighted average corresponding to each lithium composition $x_j$ calculated in step S906. More specifically, for each particle, the processor multiplies lithium composition $x_j$ of the corresponding particle by volume $V_j$ (corresponding to the capacity) of the corresponding particle, and adds the multiplied values for all the particles. Then, the processor divides the added value by the total volume (corresponding to the total capacity) of all the particles (see the equation (7)). Thereby, what is called the "position of the center of gravity" of all the particles in the lithium composition-OCP curve is calculated, and this position of the center of gravity corresponds to the SOC of the target cell.

$$SOC(t) = \frac{\sum_{j=1}^{N}\left(x_j(t) \cdot V_j\right)}{\sum_{j=1}^{N} V_j} \qquad \cdots (7)$$

In step S908, the processor determines whether or not the SOC of every cell has been estimated. When there remains a cell whose SOC has not been estimated (NO in S908), the processor returns the process to S901 and executes the process in S901 to S907 on the next cell. When the SOC estimation for every cell is completed (YES in S908), the processor ends the process.

<Simplified Model>

Next, the following describes the simplified model in the present embodiment in comparison with the comparative model.

Fig. 10 is a first conceptual diagram for illustrating a difference between the comparative model and the simplified model. As described above, a plurality of particle diameters are set in the comparative model. On the other hand, in the simplified model, all particles are set to have the same particle diameter. In other words, all the particles are equal in reaction area and capacity. There is a common point between the comparative model and the simplified model that the particle higher in reaction sequence is assigned with a smaller particle number.

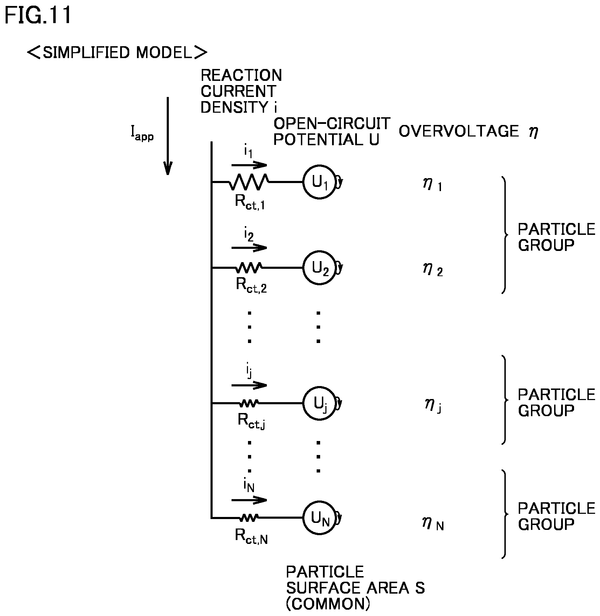

Fig. 11 is a second conceptual diagram for illustrating the difference between the comparative model and the simplified model. In the comparative model, lithium composition $x_j$ is calculated for each particle (see the above-mentioned equation (6)). On the other hand, in the simplified model, assuming that there are three particle groups respectively corresponding to three phases, the lithium composition is calculated for each of the particle groups. The following is a more specific description with reference to an example of 10 particles as in Fig. 8. Note that p is added as a suffix to a variable related to the Li-poor phase, c is added as a suffix to a variable related to the two-phase coexistence phase, and r is added as a suffix to a variable related to the Li-rich phase.

Fig. 12 is a third conceptual diagram for illustrating the difference between the comparative model and the simplified model. In the comparative model, all the particles are separately treated. In the example shown in Fig. 8 regarding the comparative model, the particles belonging to the Li-poor phase have particle numbers j of 1, 2 (j = 1, 2); the particles belonging to the two-phase coexistence phase have particle numbers j of 3, 4, 5 (j = 3, 4, 5); and the particles belonging to the Li-rich phase have particle numbers j of 6, 7, 8, 9, 10 (j = 6, 7, 8, 9, 10).

On the other hand, in the simplified model, the particles belonging to the same phase among the three phases are considered as a particle group mass. In other words, many particles are divided into: a particle group belonging to the Li-poor phase; a particle group belonging to the two-phase coexistence phase; and a particle group belonging to the Li-rich phase. Each of the three particle groups is represented by a minimum value (Min) and a maximum value (Max) of the particle numbers of the particles included in the corresponding particle group. In the example shown in Fig. 12, the particle group belonging to the Li-poor phase is represented by Min = 1 and Max = 2. The particle group belonging to the two-phase coexistence phase is represented by Min = 3 and Max = 5. The particle group belonging to the Li-rich phase is represented by Min = 6 and Max = 10.

Each of the three particle groups may be represented by the number of particles belonging to the corresponding particle group. According to the present embodiment, even when the many particle model includes thousands of particles, the variables (the minimum value and the maximum value of the particle number or the number of particles) for representing these particles can be reduced in number to be less than 100.

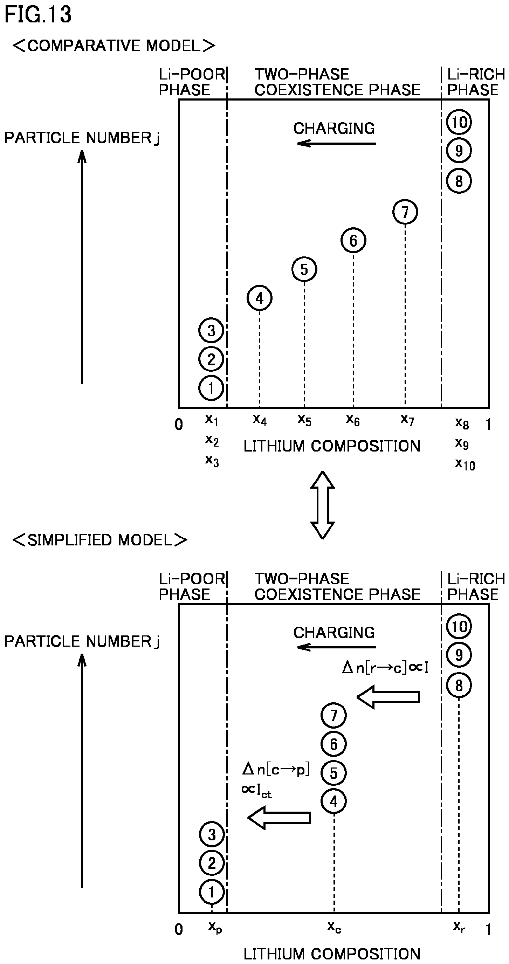

Fig. 13 is a diagram for comparing the concept of phase transition of many particles between the comparative model and the simplified model. Fig. 13 exemplifies the state in which the SOC is 50% during charging of the target cell.

In the comparative model, for each of the particles separated from each other, lithium composition $x_j$ ($x_4$ to $x_7$ in the present example) is calculated based on reaction current $I_j$ corresponding to reaction current density $i_j$ (see the above-mentioned equations (5) and (6)).

On the other hand, in the simplified model, the following condition is set. All the particles included in the particle group belonging to the two-phase coexistence phase have the same value as a lithium composition. This value is fixed in advance and denotes a representative value of the lithium composition in the two-phase coexistence phase. In the present example, the particle group belonging to the two-phase coexistence phase and represented by Min = 4 and Max = 7 has a lithium composition $x_c = 0.50$.

All the particles included in the particle group belonging to the Li-poor phase also have the same lithium composition. This lithium composition is denoted as $x_p$ that is an unfixed variable value, unlike $x_c$ in the two-phase coexistence phase. The same also applies to the Li-rich phase. The lithium composition of the particle group belonging to the Li-rich phase is denoted as $x_r$.

Further, in the simplified model, the number of particles moving among three phases is calculated using the reaction current in each phase. The reaction currents in the Li-poor phase, the two-phase coexistence phase, and the Li-rich phase are denoted as $I_p$, $I_c$, and $I_r$, respectively. The following relation is established between the sum of the three reaction currents and applied current $I_{app}$ flowing through the target cell (see the equation (8)).

$$I_{app} = I_p + I_c + I_r \qquad \cdots (8)$$

Each of reaction currents $I_p$, $I_c$, and $I_r$ can be calculated as follows. With reference to the Li-poor phase as an example for explanation, reaction current $I_p$ is calculated, for example, according to the equation (9). The lower right "p" in the summation symbol means that all the particles belonging to the Li-poor phase are defined as targets.

$$I_p = \sum_p I_j \qquad \cdots (9)$$

Alternatively, since the relation of the equation (10) is also established, reaction current $I_p$ may be calculated as one particle by summing the reaction conductivities (described later). In this case, S denotes a particle surface area common to all the particles.

$$I_p = \sum_p I_j = \sum_p \left\{ S * i_{Oj} \left[ \exp\left(\frac{0.5F}{RT}\eta_j\right) - \exp\left(\frac{-0.5F}{RT}\eta_j\right) \right] \right\}$$

$$= S * \left[ \exp\left(\frac{0.5F}{RT}\eta_j\right) - \exp\left(\frac{-0.5F}{RT}\eta_j\right) \right] \sum_p i_{Oj} \qquad \cdots (10)$$

Reaction currents $I_p$, $I_c$, and $I_r$ obtained in this way are changed in lithium composition as follows. Also in this case, with reference to the Li-poor phase as an example for explanation, a change amount $\Delta x_p$ of the lithium composition in the Li-poor phase is calculated as in the equation (11). $Q_p$ denotes the capacity of the Li-poor phase.

$$\Delta x_p = \frac{I_p \cdot \Delta t}{Q_p} \qquad \cdots (11)$$

In the simplified model, the capacity of each of the three particle groups is equal to the total sum of the capacities of the particles included in the corresponding particle group. The capacity of each of the three particle groups is proportional to the number of particles included in the corresponding particle group. Thus, as the number of particles included in a particle group increases, the capacity of this particle group increases. When the number of particles belonging to the Li-poor phase is denoted as $n_p$ and the capacity (common) of each particle is denoted as q, then, $Q_p = n_p \times q$.

By adding change amount $\Delta x_p$ of the lithium composition in the Li-poor phase to a previous value $x_p(t-1)$ of the lithium composition in the Li-poor phase, a present value $x_p(t)$ of the lithium composition in the Li-poor phase is calculated (see the equation (12)).

$$x_p(t) = x_p(t-1) + \Delta x_p \qquad \cdots (12)$$

In this case, present value $x_p(t)$ of the lithium composition in the Li-poor phase does not exceed the boundary value (x = 0.05 in the present example) between the Li-poor phase and the two-phase coexistence phase. The particles each associated with the change in lithium composition exceeding the boundary value move from the Li-poor phase to the two-phase coexistence phase.

The capacity change corresponding to the change in lithium composition exceeding the boundary value is represented as $(x_p - 0.05) \times n_p \times q$. On the other hand, when $\Delta n$ [p->c] particles move from the boundary value (x = 0.05) in the Li-poor phase to the two-phase coexistence phase (x = 0.5), the capacity change is represented as $(0.5 - 0.05) \times \Delta n$ [p->c] $\times$ q. These two capacity changes are equal to each other (see the equation (13)).

$$\left(x_p - 0.05\right) * n_p * q = (0.5 - 0.05) * \Delta n[p \to c] * q \qquad \cdots (13)$$

When the equation (13) is solved for the number $\Delta n[p \to c]$ of particles moving from the Li-poor phase to the two-phase coexistence phase, $\Delta n[p \to c]$ is represented as shown in the equation (14).

$$\Delta n[p \to c] = \frac{(x_p - 0.05) * n_p}{0.5 - 0.05} \qquad \cdots (14)$$

Thus, the lithium composition of each particle belonging to the Li-poor phase continuously changes until it reaches the boundary value (x = 0.05) in the Li-poor phase. The lithium composition of each particle belonging to the Li-poor phase does not change beyond 0.05. When the lithium composition reaches the boundary value in the Li-poor phase, the particles whose number is proportional to reaction current $I_p$ in the Li-poor phase move from the Li-poor phase to the two-phase coexistence phase. Although the movement from the Li-poor phase to the two-phase coexistence phase has been described by way of example in this case, the number $\Delta n$ of particles moving between the phases can be similarly calculated also for the movement from the two-phase coexistence phase to the Li-poor phase, the movement from the Li-rich phase to the two-phase coexistence phase, and the movement from the two-phase coexistence phase to the Li-rich phase.

Note that the reaction conductivity of each of the three particle groups is the sum of the reaction conductivities of the particles included in the corresponding particle group. The reaction conductivity of the j-th particle is the inverse of a reaction resistance ($R_{ct,j}$) of this particle. The inverse of the reaction resistance in each of the three particle groups is the inverse sum of the reaction resistances of the particles included in the corresponding particle group. Therefore, as the number of particles included in a particle group increases, the reaction resistance in this particle group decreases.

<Phase Transition>

The following more specifically describes in what way many particles undergo phase transition according to the above-described simplified model for each of charging and discharging of battery 10.

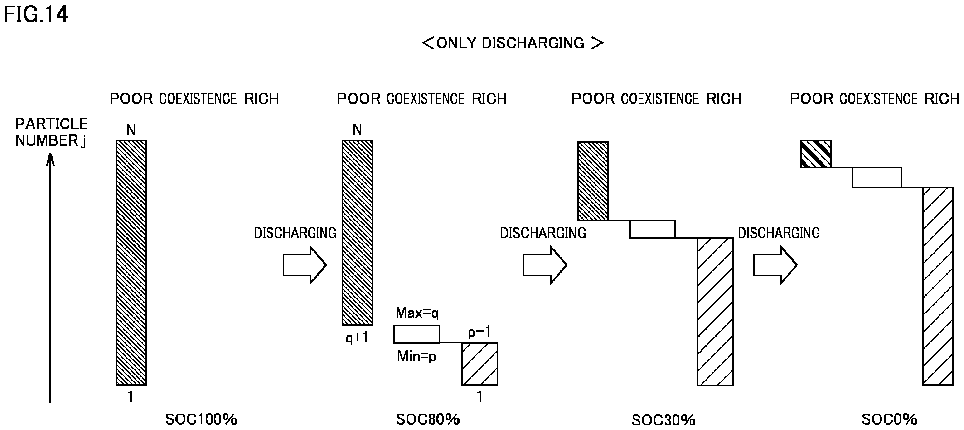

Fig. 14 is a diagram for illustrating phase transition of many particles resulting from discharging of battery 10. Fig. 14 schematically shows how the phase to which many particles belong changes when battery 10 is monotonously discharged such that the SOC changes from 100% to 0%.

When the SOC is 100%, all the particles belong to the Li-poor phase. When discharging of battery 10 is started, the particles transit to the Li-rich phase through the two-phase coexistence phase sequentially in order from the particle smaller in particle number shown in the lower part in the figure. As the SOC decreases to 80%, 30%, and 0%, the particles belonging to the Li-poor phase decrease, whereas the particles belonging to the Li-rich phase increase. In addition, the positive electrode has a surplus capacity (what is called a reserve capacity) that can be used for charging but is not yet used. Thus, even when the SOC is 0%, not all the particles belong to the Li-rich phase, but some of the particles remain in the Li-poor phase and the two-phase coexistence phase.

As described above, the plurality of particles belonging to each of the phases are specified by the minimum value and the maximum value of the particle numbers of the particles belonging to the corresponding phase. For example, when the SOC is 80%, the particle group belonging to the two-phase coexistence phase is specified by the minimum value (Min) = p and the maximum value (Max) = q of the particle numbers. The particle group belonging to the Li-rich phase is specified by Min = 1 and Max = p - 1 of the particle numbers, and the particle group belonging to the Li-poor phase is specified by Min = q + 1 and Max = N of the particle numbers.

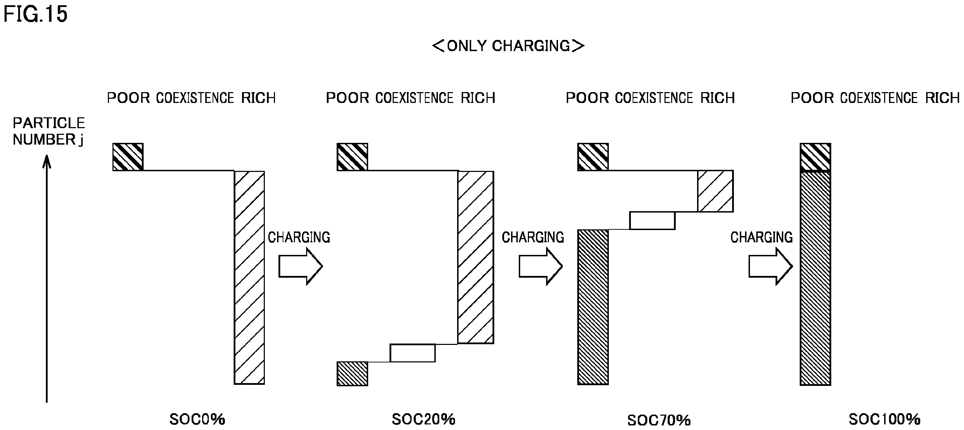

Fig. 15 is a diagram for illustrating phase transition of many particles resulting from charging of battery 10. Fig. 15 schematically shows how the phase to which many particles belong changes when battery 10 is monotonously charged such that the SOC changes from 0% to 100%.

When the SOC is 0%, most of the particles excluding the particles corresponding to the reserve capacity belong to the Li-rich phase. When charging of battery 10 is started, the particles transit to the Li-poor phase through the two-phase coexistence phase sequentially in order from the particle smaller in particle number. As the SOC increases to 20%, 70%, and 100%, the particles belonging to the Li-rich phase decrease, whereas the particles belonging to the Li-poor phase increase.

<Process Flow>

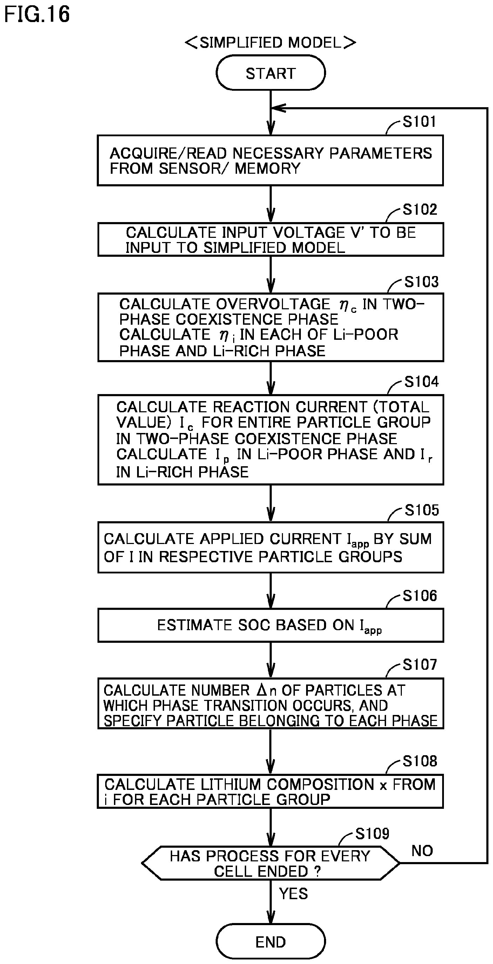

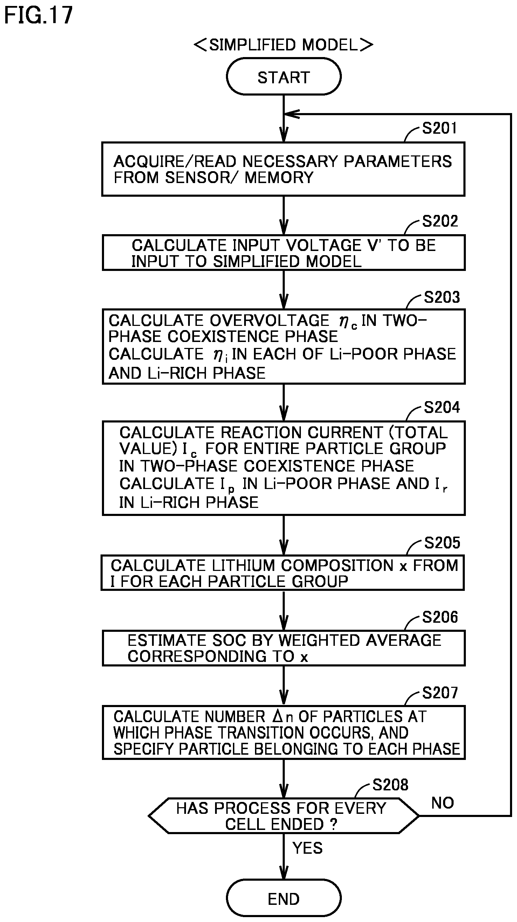

Fig. 16 is a flowchart illustrating the first example of the processing procedure of the SOC estimation process using the simplified model in the present embodiment. The process shown in this flowchart (and the process shown in the flowchart in Fig. 17 described later) is executed when a predetermined condition is satisfied (for example, for each predetermined period). Each step is implemented by software processing by battery ECU 40 (processor 401), but may be implemented by hardware (electric circuitry) disposed in battery ECU 40.

Also in the present embodiment, the SOC estimation process is executed for each "target cell". However, the SOC estimation process may be executed for the entire battery or may be executed for each of a plurality of cells (for example, for each battery module).

In S101, battery ECU 40 acquires various variables necessary for the present SOC estimation process from the sensor. Also, battery ECU 40 reads the previous values of the variables necessary for the present SOC estimation process from memory 402.

In S 102, according to the equation (15), battery ECU 40 calculates an input voltage V' to be input to the simplified model. A salt concentration overvoltage dVc(t) in the equation (15) is calculated according to the equation (16). These calculation methods are the same as those in the comparative model (see the equations (1) and (2)).

$$V'(t) = V(t) - I(t) \cdot R_d - dV_c(t) \quad \cdots (15)$$

$$dV_c(t) = (1 - \alpha) \cdot dV_c(t - 1) + \beta \cdot I(t) \quad \cdots (16)$$

In S103, battery ECU 40 calculates an overvoltage $\eta$ of each particle group. More specifically, battery ECU 40 calculates an overvoltage $\eta_c$ common for the entire particle group belonging to the two-phase coexistence phase according to the equation (17). $U_c$ in the equation (17) is a fixed value and denotes an open-circuit potential corresponding to a representative value $x_c$ (= 0.50) of the lithium composition in the two-phase coexistence phase.

$$\eta_c = V'(t) - U_c(x_c) \quad \cdots (17)$$

In addition, battery ECU 40 calculates an overvoltage $\eta_p$ for the entire particle group belonging to the Li-poor phase according to the equation (18). In the equation (18), $U_p$ is a variable value and denotes an open-circuit potential corresponding to previous value $x_p(t-1)$ of the common lithium composition in the Li-poor phase. In this case, $x_p(t-1)$ is calculated in S108 described later. Battery ECU 40 similarly calculates an overvoltage $\eta_r$ according to the equation (19) also for the entire particle group belonging to the Li-rich phase.

$$\eta_p = V'(t) - U_p(x_p(t - 1)) \quad \cdots (18)$$

$$\eta_r = V'(t) - U_r(x_r(t - 1)) \quad \cdots (19)$$

In S104, according to the equation (20), battery ECU 40 calculates a reaction current (a total value of the reaction currents of all the particles belonging to the two-phase coexistence phase) $I_c$ for the entire particle group belonging to the two-phase coexistence phase. Note that an exchange current density io in the equations (20) to (22) is set to become smaller as the particle number becomes larger (i.e., as the order is lower in reaction sequence). For example, as the particle number becomes larger, the exchange current density linearly becomes lower ($i_{Oj}$ = 1/$R_O$ × j). The exchange current density can be set by referring to this relation determined in advance.

$$I_c = \sum_c i_c = \sum_c i_{Oc}\left[\exp\left(\frac{0.5F}{RT}\eta_c\right) - \exp\left(\frac{-0.5F}{RT}\eta_c\right)\right]$$
$$= i_{Osumc}\left[\exp\left(\frac{0.5F}{RT}\eta_c\right) - \exp\left(\frac{-0.5F}{RT}\eta_c\right)\right] \quad \cdots (20)$$

Similarly, also for the entire particle group belonging to the Li-poor phase and the entire particle group belonging to the Li-rich phase, battery ECU 40 respectively calculates reaction currents $I_p$ and $I_r$ according to the equations (21) and (22).

$$I_p = i_{Osump}\left[\exp\left(\frac{0.5F}{RT}\eta_p\right) - \exp\left(\frac{-0.5F}{RT}\eta_p\right)\right] \quad \cdots (21)$$

$$I_r = i_{Osumr}\left[\exp\left(\frac{0.5F}{RT}\eta_r\right) - \exp\left(\frac{-0.5F}{RT}\eta_r\right)\right] \quad \cdots (22)$$

In S 105, battery ECU 40 calculates applied current $I_{app}$ flowing through the target cell by calculating the sum of the reaction currents in the respective phases calculated in S104 (see the equation (23)).

$$I_{app} = I_p + I_c + I_r \quad \cdots (23)$$

In S106, battery ECU 40 estimates a present value SOC(t) of the SOC of the target cell by adding, to a previous value SOC(t-1) of the SOC of the target cell, a value obtained by dividing applied current $I_{app}$ flowing through the target cell by a battery capacity C of the target cell (see the equation (24)).

$$SOC(t) = SOC(t-1) + \frac{I_{app}}{C} \quad \cdots (24)$$

In S107, based on reaction currents $I_p$, $I_c$, and $I_r$ in the respective phases, battery ECU 40 calculates the number Δn of particles at which phase transition occurs among the three phases. In other words, battery ECU 40 calculates: the number Δn [r->c] of particles at which phase transition from the Li-rich phase to the two-phase coexistence phase occurs; the number Δn [c->p] of particles at which phase transition from the two-phase coexistence phase to the Li-poor phase occurs; the number Δn [p->c] of particles at which phase transition from the Li-poor phase to the two-phase coexistence phase occurs; and the number Δn [c->r] of particles at which phase transition from the two-phase coexistence phase to the Li-rich phase occurs. Since these calculation methods have been described in detail with reference to the equations (9) to (14), the description thereof will not be repeated.

Then, based on the calculated number Δn of particles, battery ECU 40 specifies which particles belong to which phase. As described above, each of the three particle groups can be represented by the minimum value (Min) and the maximum value (Max) of the particle numbers of the particles included in the corresponding particle group. Further, battery ECU 40 calculates present values $n_c(t)$, $n_p(t)$, and $n_r(t)$ of the numbers of particles belonging to the respective phases (see the equations (25) to (27)). The number of particles can be used in the process in S206 (described later).

$$n_c(t) = n_c(t-1) + \Delta n[r \rightarrow c] - \Delta n[c \rightarrow p] + \Delta n[p \rightarrow c] - \Delta n[c \rightarrow r] \quad \cdots (25)$$

$$n_p(t) = n_p(t-1) + \Delta n[c \rightarrow p] - \Delta n[p \rightarrow c] \quad \cdots (26)$$

$$n_r(t) = n_r(t-1) + \Delta n[c \rightarrow r] - \Delta n[r \rightarrow c] \qquad \cdots (27)$$

In S108, for the entire particle group belonging to the Li-poor phase, battery ECU 40 calculates the present value of a lithium composition $x_p$ in this entire particle group by adding, to the previous value of lithium composition $x_p$ in this entire particle group, a value obtained by dividing the product of reaction current $I_p$ calculated in S104 and a period $\Delta t$ of the SOC estimation process by a capacity (the total capacity in the Li-poor phase) $Q_p$ (see the equation (28)). A similar process is performed also for the Li-rich phase (see the equation (29)). When $x_p(t) > 0.05$, then, $x_p(t)$ is set at 0.05 ($x_p(t) = 0.05$). When $x_p(t) < 0.95$, then, $x_p(t)$ is set at 0.95 ($x_p(t) = 0.95$). These values are used in the process in S103 (see the equations (18) and (19)) in the next SOC estimation process.

$$x_p(t) = x_p(t-1) + \frac{I_p(t) \cdot \Delta t}{Q_p} \qquad \cdots (28)$$

$$x_r(t) = x_r(t-1) + \frac{I_r(t) \cdot \Delta t}{Q_r} \qquad \cdots (29)$$

In S 109, battery ECU 40 determines whether or not the SOCs of all the cells have been estimated. When there remains a cell whose SOC has not been estimated (NO in S 109), battery ECU 40 returns the process to S 101 and executes the process in S 101 to S 108 on the next cell. When the SOC estimation for every cell has been completed (YES in S109), battery ECU 40 ends the process.

Fig. 17 is a flowchart illustrating the second example of the processing procedure of the SOC estimation process using the simplified model in the present embodiment. Since the process in S201 to S204 is the same as that in S 101 to S104 in the first example (see Fig. 16), the description thereof will not be repeated.

In S205, battery ECU 40 respectively calculates lithium compositions $x_p$ and $x_r$ for the entire particle group belonging to the Li-poor phase and the entire particle group belonging to the Li-rich phase. The above-mentioned process is the same as that in S108 (see the equations (28) and (29)).

In S206, battery ECU 40 estimates the SOC of the target cell based on lithium composition x in each of the three phases. More specifically, battery ECU 40 adds, for the three phases, the resultant values each obtained by multiplying lithium composition x in each phase by the number n of particles included in the corresponding phase. Then, battery ECU 40 divides the added value by the total number N of particles (see the equation (30)). Thereby, the position of the center of gravity of all the particles is calculated and thus can be set as the SOC of the target cell.

$$SOC(t) = \frac{1}{N} \sum (x_p \cdot n_p + x_c \cdot n_c + x_r \cdot n_r) \qquad \cdots (30)$$

The subsequent process in S207 and S208 is the same as that in S 107 and S109 in the first example.

In the first example (see Fig. 16) of the processing procedure in the SOC estimation process, there is a concern that the numerical calculation error may be accumulated, though this numerical calculation error is not so large as the accumulation error of the detection values from various sensors (a voltage sensor, a current sensor, and the like). On the other hand, the second example (see Fig. 17) of the processing procedure in the SOC estimation process is less influenced by the accumulation of numerical calculation errors than in the case of the first example. This is because, for example, when the error becomes large during charging and the estimated SOC becomes higher than the actual SOC (the true value), there occurs a feedback in which the estimated OCV rises - overvoltage $\eta$ is reduced - the estimated current is reduced to be smaller than the actual current - the rate at which the estimated SOC rises becomes slower than the rate at which the actual SOC rises, with the result that the estimated SOC comes close to the true value.

As described above, in the present embodiment, it is considered that the particles belonging to the two-phase coexistence phase are regarded as a particle group mass, and this particle group has a typical common lithium composition $x_c$ (= 0.50) in the two-phase coexistence phase as a fixed value. In addition, it is considered that the particles belonging to the Li-poor phase are regarded as a particle group mass, and this particle group also has a common lithium composition $x_p$ in the Li-poor phase. Also, it is considered that the particles belonging to the Li-rich phase are regarded as a particle group mass, and this particle group has a common lithium composition $x_r$ in the Li-rich phase. Then, for each phase, open-circuit potentials U of all the particles are collectively calculated, and thereby, overvoltages $\eta$ (and thus, reaction current densities i) are also collectively calculated. Thereby, the variables for representing particles can be reduced as compared with the comparative model in which all the particles are separately treated. Therefore, according to the present embodiment, the computation load on battery ECU 40 (processor 401) can be reduced while estimating the SOC of battery 10 with high accuracy using the many particle model.

[Modifications]

<Bar-Coding>

When charging and discharging of battery 10 are repeated, in other words, when switching between charging and discharging of battery 10 is performed repeatedly, the variables representing the particles belonging to the two-phase coexistence phase (a pair of variables including the maximum value and the minimum value of the particle number) increase. This may result in a situation referred to by the present inventors as "bar-coding" of a variable.

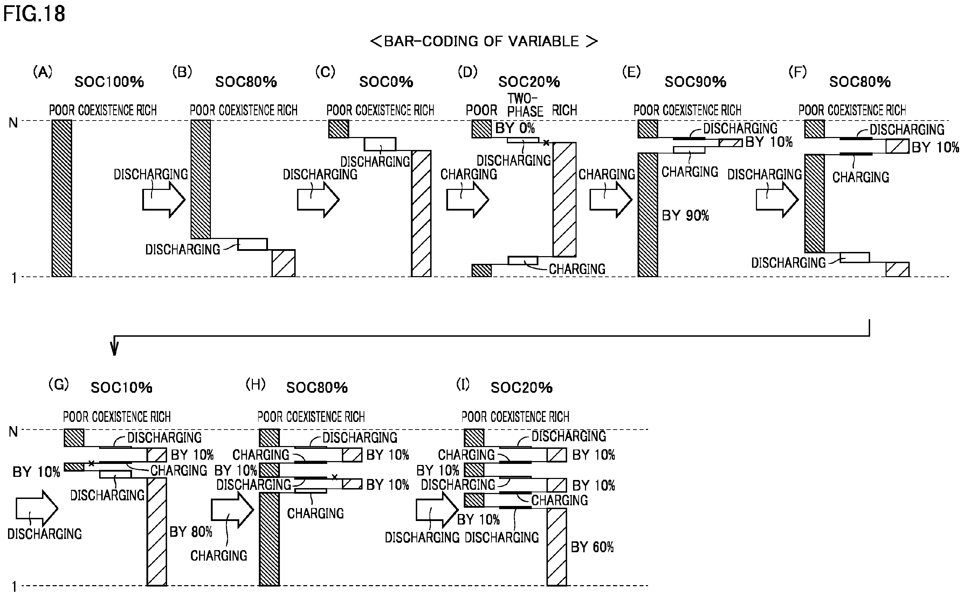

Fig. 18 is a conceptual diagram for illustrating bar-coding of a variable. The particle number located at a higher portion in the figure is larger. Thus, in the following description, transition of each particle larger in particle number is also referred to as transition from the "upper side", and transition of each particle smaller in particle number is also referred to as transition from the "lower side".

First, it is assumed that the SOC is 100% at which all the particles belong to the Li-poor phase (see Fig. 18(A)). When the target cell is discharged in this state, the particles belonging to the Li-poor phase transit to the Li-rich phase through the two-phase coexistence phase sequentially in order from the particle on the lower side (see Fig. 18(B)). In the present example, the target cell is discharged until the SOC reaches 0% (see Fig. 18(C)). At this time, some of the particles remain in the Li-poor phase and the two-phase coexistence phase.

Then, the target cell is charged such that the SOC changes from 0% through 20% to 90% (see Figs. 18(D) and 18(E)). Then, the particles belonging to the Li-rich phase transit to the Li-poor phase through the two-phase coexistence phase sequentially in order from the particle on the lower side. At this time, the particles different from those having transitioned to the two-phase coexistence phase by the first discharging are to belong to the two-phase coexistence phase by the first charging. In other words, the particles belonging to the two-phase coexistence phase are divided into two particle groups.

Subsequently, the target cell is discharged such that the SOC changes from 90% through 80% to 10% (see Figs. 18(F) and 18(G)). Then, the particles belonging to the Li-poor phase again transit to the Li-rich phase through the two-phase coexistence phase sequentially in order from the particle on the lower side. As a result, the particles belonging to the two-phase coexistence phase are divided into three particle groups.

Similarly, the target cell is charged such that the SOC changes from 10% to 80% (see Fig. 18(H)). Thereby, the particles belonging to the Li-rich phase transit to the Li-poor phase through the two-phase coexistence phase sequentially in order from the particle on the lower side. As a result, the particles belonging to the two-phase coexistence phase are divided into four particle groups.

Finally, the target cell is discharged such that the SOC changes from 80% to 20% (see Fig. 18(I)). Thereby, the particles belonging to the Li-poor phase transit to the Li-rich phase through the two-phase coexistence phase sequentially in order from the particle on the lower side (from the particle smaller in particle number). As a result, the particles belonging to the two-phase coexistence phase are divided into five particle groups.

In this way, each time switching between charging and discharging of the target cell is performed, some of the particles remain in the two-phase coexistence phase, so that the particle group including the particles belonging to the two-phase coexistence phase increases in number. In the case as shown in Fig. 18, each of the plurality of particle groups belonging to the two-phase coexistence phase is represented like a thin line and thereby appears as if it is a bar code. Since this bar-coding means an increase in variable that represents the particle belonging to the two-phase coexistence phase, it is desirable to avoid bar-coding from the viewpoint of reducing the computation load on battery ECU 40. Thus, in the present modification, three additional rules are set in order to avoid bar-coding and thereby reduce the computation load on battery ECU 40.

<Additional Rules>

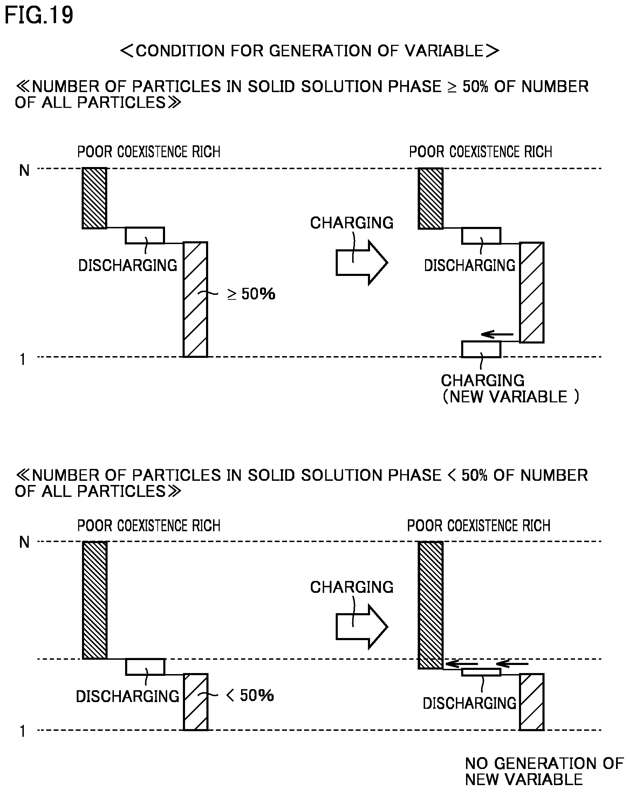

Fig. 19 is a diagram for illustrating the first additional rule. The first additional rule imposes a condition on generation of a variable representing a particle group belonging to the two-phase coexistence phase. More specifically, when switching between charging and discharging of the target cell is performed, and if the number of particles in the solid solution phase to which the particles have transited immediately before such switching is equal to or greater than a reference value REF, generation of a new variable is permitted. On the other hand, when the number of particles in the solid solution phase to which the particles have transited immediately before such switching is less than reference value REF, generation of a new variable is prohibited. In this case, the solid solution phase to which the particles have transited immediately before switching is a phase from which the particles transit (i.e., the lowest phase) in accordance with switching between charging and discharging of the target cell, and specifically, a Li-rich phase during charging of the target cell, and a Li-poor phase during discharging of the target cell. Reference value REF, which may be arbitrarily set, is 50% of the total number N of particles (REF = N/2) in the present example.

With reference to an example shown in Fig. 19 for explanation, it is considered that (1) in the case where the number of particles in the Li-rich phase as the lowermost solid solution phase is equal to or greater than reference value REF (see an upper diagram in Fig. 19), in accordance with switching from discharging to charging of the target cell, the particles belonging to the Li-rich phase transit to the Li-poor phase through the two-phase coexistence phase sequentially in order from the particle on the lower side. This concept is the same as that described with reference to Fig. 18, and a variable for representing the two-phase coexistence phase is newly generated.

On the other hand, it is considered that (2) in the case where the number of particles in the Li-rich phase is less than reference value REF (see a lower diagram in Fig. 19), in accordance with switching from discharging to charging of the target cell, the particles on the upper side (the particles larger in particle number) among the particles belonging to the two-phase coexistence phase sequentially transit to the Li-poor phase, in place of the particles on the lower side (the particles smaller in particle number) among the particles belonging to the Li-rich phase. Further, it is considered that the particles on the upper side sequentially transit also from the Li-rich phase to the two-phase coexistence phase.

In this way, when switching between charging and discharging of the target cell is performed, variables are newly generated only when (1) the condition is satisfied that the number of particles in the solid solution phase from which the particles transit is equal to or greater than reference value REF. This means that (1A) when the target cell being charged is switched to be discharged, and only when the target cell undergoes a sufficient change in SOC before this switching and is continuously charged, then, variables are newly generated, or (1B) when the target cell being discharged is switched to be charged, and only when the target cell undergoes a sufficient change in SOC before this switching and is continuously discharged, then, variables are newly generated.

On the other hand, (2) when the above-described condition is not satisfied (when the number of particles in the solid solution phase from which the particles transit is less than reference value REF), it is considered that the particles may move in the following manner. (2A) When the target cell being charged is switched to be discharged, and when charging of the target cell before this switching does not cause a significant change in SOC, no variable is generated. Further, (2B) when the target cell being discharged is switched to be charged, and when discharging of the target cell before this switching does not cause a significant change in SOC, no variable is generated. In short, it is considered that, when switching between charging and discharging of the target cell is frequently performed, the particles belonging to the two-phase coexistence phase return to the solid solution phase to which these particles have belonged before the switching.

In this case, the description has been given using the "number of particles" belonging to the solid solution phase. The "capacity" in the solid solution phase is proportional to the number of particles belonging to the solid solution phase. Thus, the number of particles may be interchanged with the capacity. Reference value REF corresponds to the capacity equivalent to 50% of the SOC of the target cell.

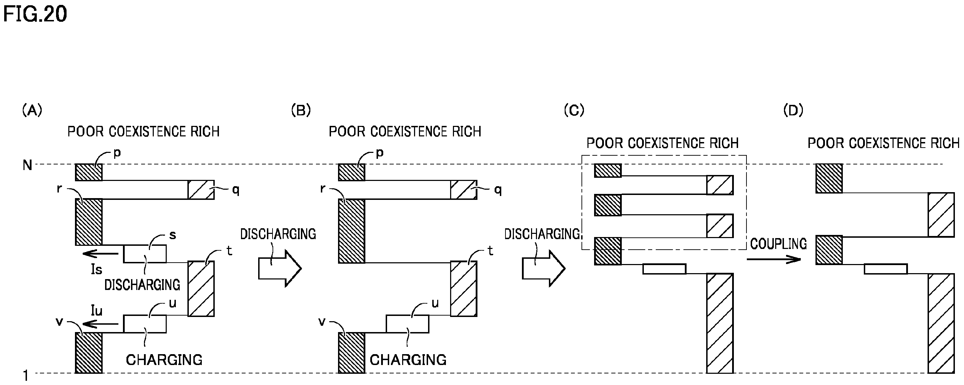

Fig. 20 is a diagram for illustrating the second and third additional rules. The second additional rule is for, based on the first additional rule, reliably reducing the variables adopted for representing the particles belonging to the two-phase coexistence phase and immediately eliminating the two-phase coexistence phase. More specifically, according to a condition imposed as the second additional rule, a current Ic resulting from the phase transition from the uppermost two-phase coexistence phase (the two-phase coexistence phase to which the particle having the largest particle number belongs) to the solid solution phase is larger than the current value determined based on: a current Iout resulting from the particles that undergo phase transition from the two-phase coexistence phase; and a change in the number $\Delta n$ of particles between the phases that results from the most recent charging and discharging (see the equation (31)). The right side of the equation (31) corresponds to the "set value" according to the present disclosure.

$$|Ic| > |I_{out}| \times \frac{\Delta n}{REF} \qquad \cdots (31)$$

The following is a description with reference to an example shown in Fig. 20. It is assumed that the most recently discharged target cell is charged. The numbers of particles in seven phases are denoted as p, q, r, s, t, u, and v. In this case, Is denotes a current resulting from the particles that undergo phase transition from the two-phase coexistence phase including the number s of particles generated by past discharging. Also, Iu denotes a current resulting from the particles that undergo phase transition from the two-phase coexistence phase including the number u of particles generated by the most recent charging. The sum of the absolute values of these two currents is |Iout| in the equation (31), i.e., the total value (absolute value) of the currents resulting from the particles that undergo phase transition from the two-phase coexistence phase (|Iout| = |Is| + |Iu|).

Based on the first additional rule, a new variable is generated according to the change in number of particles resulting from the most recent charging of the target cell, i.e., when the number $\Delta n = v$ of particles having undergone phase transition from the Li-rich phase in accordance with charging of the target cell becomes equal to or greater than the reference value. The second additional rule is applied for, prior to generation of a new variable, causing the particles to actively undergo phase transition from the uppermost two-phase coexistence phase (the two-phase coexistence phase including the number s of particles in the present example) such that the particles belonging to the two-phase coexistence phase become zero. Specifically, current Is resulting from the particles that undergo phase transition from the two-phase coexistence phase including the number s of particles to the Li-poor phase is determined so as to satisfy the equation (32). Since the current resulting from the particles that undergo phase transition is proportional to the reaction current density of these particles, the right side of the equation (32) is determined based on the product of: the reaction current density of the particles belonging to the two-phase coexistence phase; and the number (u + v) of the particles having undergone phase transition from the Li-rich phase. By applying the equation (32) according to the second additional rule, the number s of particles is reliably set to become zero until the condition for permitting generation of a new variable is satisfied.

$$|I_s| > (|I_s| + |I_u|) \times \frac{u + v}{REF} \quad \cdots (32)$$

Based on such an idea that the current corresponding to the immediately preceding change in the number of particles flows from the two-phase coexistence phase to the solid solution phase before a new variable is generated, the uppermost two-phase coexistence phase can be immediately eliminated. In the case where the two-phase coexistence phase including the number s of particles remains when the number (u + v) of particles in the solid solution phase comes close to reference value REF in accordance with charging of the target cell, it is preferable to assume that all the currents (Iout) flow from the two-phase coexistence phase including the number s of particles.

The third additional rule is for combining a plurality of separated solid solution phases based on the second additional rule. Fig. 20(C) shows the state in which discharging of the target cell is continued from the state shown in Fig. 20(B), and the capacity in the Li-rich phase including the particles relatively small in particle number reaches a reference capacity Cref. In the present example, before coupling, above the two-phase coexistence phase, the Li-poor phase is separated into three phases and the Li-rich phase is separated into two phases (see the frame indicated by a dash-dotted line). In this case, three pairs of variables are required to represent the Li-poor phase, and two pairs of variables are required to represent the Li-rich phase.

According to the third additional rule, the Li-poor phases are coupled to each other and the Li-rich phases are coupled to each other (see Fig. 20(D)). Thereby, although the Li-poor phases are still two separated phases even after coupling, the Li-rich phases are coupled into one phase. Thus, the variables for representing the Li-poor phase are reduced from three pairs to two pairs, and the variables for representing the Li-rich phase are reduced to one pair. Therefore, the computation load on processor 401 can be reduced.

Although the embodiments of the present disclosure have been described, it should be understood that the embodiments disclosed herein are illustrative and non-restrictive in every respect. The scope of the present disclosure is defined by the scope of the claims, and is intended to include any modifications within the meaning and scope equivalent to the scope of the claims.

**Claims**

1.  A method of managing a storage battery (10) using a processor (401), the storage battery (10) having a positive electrode (1) containing a positive electrode active material (121), wherein

    the positive electrode active material (121) has a plurality of phases that are different from each other in content of charge carriers in the positive electrode active material,
    the plurality of phases include

    a rich phase in which the charge carriers are high in content,
    a poor phase in which the charge carriers are low in content, and
    a two-phase coexistence phase in which the rich phase and the poor phase coexist, and

    the method comprises, in a many particle model in which the positive electrode active material (121) is represented by a plurality of particles each distinguished by a particle number indicating a reaction sequence of the positive electrode active material (121), assuming that the charge carriers are equal in content among one or more particles belonging to each of the rich phase, the poor phase, and the two-phase coexistence phase:

    for each of the plurality of phases, calculating an overvoltage of a particle belonging to a corresponding one of the plurality of phases by the processor (401) based on a measured voltage of the storage battery (10), a measured current of the storage battery (10), and an open-circuit potential of the particle belonging to the corresponding one of the plurality of phases;

for each of the plurality of phases, calculating a reaction current density by the processor (401) based on the overvoltage; and

estimating an SOC of the storage battery (10) by the processor (401) based on the reaction current density in each of the plurality of phases.

2. The method according to claim 1, wherein

in the many particle model,

the content of the charge carriers is a predetermined fixed value among particles belonging to the two-phase coexistence phase, and

the content of the charge carriers is a variable value that varies according to the reaction current density (i) among particles belonging to the rich phase and (ii) among particles belonging to the poor phase.

3. The method according to claim 2, wherein

the many particle model includes, as a variable for representing the plurality of particles,

a minimum value and a maximum value of the particle number of a particle belonging to the two-phase coexistence phase, or

the number of particles belonging to the two-phase coexistence phase.

4. The method according to claim 3, wherein the variable is smaller in number than 100.

5. The method according to any one of claims 1 to 4, wherein

in the many particle model, the reaction sequence of the positive electrode active material (121) is determined by reaction resistances of the plurality of particles, and

a difference of the reaction resistances between particles whose particle numbers are consecutive among the plurality of particles is smaller than a prescribed value.

6. The method according to any one of claims 1 to 4, wherein, in the many particle model, it is assumed that the plurality of particles are equal in particle diameter such that the plurality of particles are equal in reaction area and capacity.

7. The method according to any one of claims 1 to 4, wherein

the calculating the overvoltage includes, for each of the plurality of phases,

calculating the open-circuit potential from the content of the charge carriers by referring to a relation between the content of the charge carriers and the open-circuit potential, and

calculating the overvoltage based on a salt concentration overvoltage resulting from a concentration gradient of the charge carriers, in addition to the measured voltage, the measured current, and the open-circuit potential.

8. The method according to any one of claims 1 to 4, wherein

the estimating the SOC of the storage battery (10) includes

for each of the plurality of phases, multiplying the reaction current density in a corresponding one of the plurality of phases, the number of particles belonging to the corresponding one of the plurality of phases, and a surface area of a particle belonging to the corresponding one of the plurality of phases,

calculating an applied current flowing through the storage battery (10) by adding multiplied values for the plurality of phases, and

estimating a present value of the SOC of the storage battery (10) by adding, to a previous value of the SOC of the storage battery (10), a value obtained by dividing the applied current by a battery capacity of the storage battery (10).

9. The method according to any one of claims 1 to 4, wherein

the estimating the SOC of the storage battery (10) includes

for each of the plurality of phases, calculating the content of the charge carriers in a corresponding one of the plurality of phases by multiplying the reaction current density in the corresponding one of the plurality of phases, a surface area of a particle belonging to the corresponding one of the plurality of phases, and an elapsed time period since a previous estimation of the SOC of the storage battery (10),

for each of the plurality of phases, multiplying the content of the charge carriers by the number of particles belonging to the corresponding one of the plurality of phases,

adding multiplied values for the plurality of phases, and

estimating the SOC of the storage battery (10) by dividing an added value by a total number of particles in the plurality of particles.

10. The method according to any one of claims 1 to 4, wherein

in the many particle model,

one of the rich phase and the poor phase is defined as a first phase, and
the other of the rich phase and the poor phase is defined as a second phase, and

when switching between charging and discharging of the storage battery (10) is performed after particles belonging to the first phase transit to the second phase in accordance with charging and discharging of the storage battery (10),

it is assumed that, when the number of particles belonging to the second phase exceeds a reference value, the particles belonging to the second phase undergo phase transition to the first phase through the two-phase coexistence phase, and
it is assumed that, when the number of particles belonging to the second phase is below the reference value, the particles belonging to the two-phase coexistence phase return to the first phase.

11. The method according to claim 10, wherein

in the many particle model, a current flowing when the particles belonging to the two-phase coexistence phase are returned to the first phase is set to be larger than a set value, and
the set value is determined based on a product of

the reaction current density of the particles belonging to the two-phase coexistence phase; and
the number of particles that have undergone phase transition from the first phase to the second phase before switching between charging and discharging of the storage battery (10).

12. The method according to claim 11, wherein, in the many particle model, when the particles belonging to the rich phase or the poor phase are separated into two or more particle groups, at least some of the two or more particle groups are coupled to each other.

13. A battery management system (100) comprising the processor (401) according to any one of claims 1 to 4.

FIG.1

FIG.2

FIG.3

FIG.4

FIG.5

<MANY PARTICLE MODEL>

# FIG.6

<COMPARATIVE MODEL>

```
                    ┌──────────────┐
                    │    START     │
                    └──────┬───────┘
                           │            ┌─S901
                           ▼
          ┌─────────────────────────────────────────┐
          │ ACQUIRE/READ NECESSARY PARAMETERS        │
          │ FROM SENSOR/ MEMORY                      │
          └─────────────────────┬───────────────────┘
                           │            ┌─S902
                           ▼
          ┌─────────────────────────────────────────┐
          │ CALCULATE INPUT VOLTAGE V' TO BE         │
          │ INPUT TO COMPARATIVE MODEL               │
          └─────────────────────┬───────────────────┘
                           │            ┌─S903
                           ▼
          ┌─────────────────────────────────────────┐
          │ CALCULATE OVERVOLTAGE ηj FROM V'         │
          │ FOR EACH PARTICLE                        │
          └─────────────────────┬───────────────────┘
                           │            ┌─S904
                           ▼
          ┌─────────────────────────────────────────┐
          │ CALCULATE REACTION CURRENT DENSITY       │
          │ ij FOR EACH PARTICLE BASED ON ηj         │
          └─────────────────────┬───────────────────┘
                           │            ┌─S905
                           ▼
          ┌─────────────────────────────────────────┐
          │ CALCULATE REACTION CURRENT Ij FROM ij    │
          │ FOR EACH PARTICLE                        │
          └─────────────────────┬───────────────────┘
                           │            ┌─S906
                           ▼
          ┌─────────────────────────────────────────┐
          │ CALCULATE LITHIUM COMPOSITION xj         │
          │ FROM Ij FOR EACH PARTICLE                │
          └─────────────────────┬───────────────────┘
                           │            ┌─S907
                           ▼
          ┌─────────────────────────────────────────┐
          │ ESTIMATE SOC BY WEIGHTED AVERAGE         │
          │ CORRESPONDING TO xj                      │
          └─────────────────────┬───────────────────┘
                           │            ┌─S908
                           ▼                        NO
          ╱──────────────────────────────────────╲────────┐
          ╲ HAS PROCESS FOR EVERY CELL ENDED ?    ╱        │
          ╲──────────────────────────────────────╱         │
                           │ YES
                           ▼
                    ┌──────────────┐
                    │     END      │
                    └──────────────┘
```

# FIG.7

\<COMPARATIVE MODEL\>

MORE LIKELY TO REACT

LESS LIKELY TO REACT

1    N-2   N-1   N    PARTICLE NUMBER j

# FIG.8

\<COMPARATIVE MODEL\>

Li-POOR PHASE | TWO-PHASE COEXISTENCE PHASE | Li-RICH PHASE

OCP $(U_j)$

$U_5$

$U_4$

$U_3$

LITHIUM COMPOSITION (x in $Li_xFePO_4$)

j=1, 2          j=3, 4, 5          j=6, 7, 8, 9, 10

## FIG.9

<COMPARATIVE MODEL>

## FIG.10

<SIMPLIFIED MODEL>

FIG.11

<SIMPLIFIED MODEL>

## FIG.12

<SIMPLIFIED MODEL>

# FIG.13

\<COMPARATIVE MODEL\>

\<SIMPLIFIED MODEL\>

## FIG.14

<ONLY DISCHARGING >

PARTICLE NUMBER j

POOR COEXISTENCE RICH

POOR COEXISTENCE RICH

POOR COEXISTENCE RICH

POOR COEXISTENCE RICH

DISCHARGING

DISCHARGING

DISCHARGING

Max=q

q+1

p−1

Min=p

SOC100%

SOC80%

SOC30%

SOC0%

# FIG.15

<ONLY CHARGING>

PARTICLE
NUMBER j

POOR COEXISTENCE RICH    POOR COEXISTENCE RICH    POOR COEXISTENCE RICH    POOR COEXISTENCE RICH

CHARGING    CHARGING    CHARGING

SOC0%    SOC20%    SOC70%    SOC100%

EP 4 492 528 A2

## FIG.16

<SIMPLIFIED MODEL>

```
                    ( START )
                        │
                        ▼
        ┌──────────────────────────────────┐  ⟋S101
        │ ACQUIRE/READ NECESSARY PARAMETERS │
        │ FROM SENSOR/ MEMORY               │
        └──────────────────────────────────┘
                        │
                        ▼
        ┌──────────────────────────────────┐  ⟋S102
        │ CALCULATE INPUT VOLTAGE V' TO BE  │
        │ INPUT TO SIMPLIFIED MODEL         │
        └──────────────────────────────────┘
                        │
                        ▼
        ┌──────────────────────────────────┐  ⟋S103
        │ CALCULATE OVERVOLTAGE η c IN TWO- │
        │ PHASE COEXISTENCE PHASE           │
        │ CALCULATE η i IN EACH OF Li-POOR  │
        │ PHASE AND Li-RICH PHASE           │
        └──────────────────────────────────┘
                        │
                        ▼
        ┌──────────────────────────────────┐  ⟋S104
        │ CALCULATE REACTION CURRENT (TOTAL │
        │ VALUE) I c FOR ENTIRE PARTICLE GROUP │
        │ IN TWO-PHASE COEXISTENCE PHASE    │
        │ CALCULATE I p IN Li-POOR PHASE AND I r │
        │ IN Li-RICH PHASE                  │
        └──────────────────────────────────┘
                        │
                        ▼
        ┌──────────────────────────────────┐  ⟋S105
        │ CALCULATE APPLIED CURRENT Iapp BY SUM │
        │ OF I IN RESPECTIVE PARTICLE GROUPS │
        └──────────────────────────────────┘
                        │
                        ▼
        ┌──────────────────────────────────┐  ⟋S106
        │ ESTIMATE SOC BASED ON Iapp        │
        └──────────────────────────────────┘
                        │
                        ▼
        ┌──────────────────────────────────┐  ⟋S107
        │ CALCULATE NUMBER Δn OF PARTICLES AT │
        │ WHICH PHASE TRANSITION OCCURS, AND │
        │ SPECIFY PARTICLE BELONGING TO EACH PHASE │
        └──────────────────────────────────┘
                        │
                        ▼
        ┌──────────────────────────────────┐  ⟋S108
        │ CALCULATE LITHIUM COMPOSITION x FROM │
        │ i FOR EACH PARTICLE GROUP         │
        └──────────────────────────────────┘
                        │
                        ▼
              ⟋S109
        ╱ HAS PROCESS FOR EVERY ╲    NO
        ╲      CELL ENDED ?      ╱ ──────
                        │
                      YES│
                        ▼
                    (  END  )
```

# FIG.17

<SIMPLIFIED MODEL>

START

S201
ACQUIRE/READ NECESSARY PARAMETERS FROM SENSOR/ MEMORY

S202
CALCULATE INPUT VOLTAGE V' TO BE INPUT TO SIMPLIFIED MODEL

S203
CALCULATE OVERVOLTAGE $\eta_c$ IN TWO-PHASE COEXISTENCE PHASE
CALCULATE $\eta_i$ IN EACH OF Li-POOR PHASE AND Li-RICH PHASE

S204
CALCULATE REACTION CURRENT (TOTAL VALUE) $I_c$ FOR ENTIRE PARTICLE GROUP IN TWO-PHASE COEXISTENCE PHASE
CALCULATE $I_p$ IN Li-POOR PHASE AND $I_r$ IN Li-RICH PHASE

S205
CALCULATE LITHIUM COMPOSITION x FROM I FOR EACH PARTICLE GROUP

S206
ESTIMATE SOC BY WEIGHTED AVERAGE CORRESPONDING TO x

S207
CALCULATE NUMBER $\Delta n$ OF PARTICLES AT WHICH PHASE TRANSITION OCCURS, AND SPECIFY PARTICLE BELONGING TO EACH PHASE

S208
HAS PROCESS FOR EVERY CELL ENDED ? — NO

YES

END

## FIG.18

<BAR-CODING OF VARIABLE>

## FIG.19

<CONDITION FOR GENERATION OF VARIABLE>

≪NUMBER OF PARTICLES IN SOLID SOLUTION PHASE ≥ 50% OF NUMBER OF ALL PARTICLES≫

≪NUMBER OF PARTICLES IN SOLID SOLUTION PHASE < 50% OF NUMBER OF ALL PARTICLES≫

FIG.20

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023115766 A

- JP 2018169398 A

**Non-patent literature cited in the description**

- **HIROKI KONDO** ; **TSUYOSHI SASAKI** ; **PALLAB BARAI** ; **VENKAT SRINIVASAN**. Comprehensive Study of the Polarization Behavior of LiFePO4 Electrodes Based on a Many-Particle Model. *Journal of The Electrochemical Society*, 06 July 2018, vol. 165 (10)

- **TSUYOSHI SASAKI** ; **YOSHIO UKYO** ; **PETRA NOVAK**. Memory effect in a lithium-ion battery. *Nature materials*, June 2013